# FASCICULE DE BREVET EUROPEEN

(11) **EP 3 937 215 B1**
(45) Date de publication et mention de la délivrance du brevet: **18.10.2023**
(21) Numéro de dépôt: 21181810.9
(22) Date de dépôt: 25.06.2021
(51) Int. Cl.: H01L 21/67

(54) **MASQUE DE POSITIONNEMENT, SYSTÈME ET PROCÉDÉ POUR LA FABRICATION D'UN DISPOSITIF OPTOÉLECTRONIQUE**
POSITIONIERUNGSMASKE, SYSTEM UND VERFAHREN ZUR HERSTELLUNG EINER OPTOELEKTRISCHEN VORRICHTUNG
POSITIONING MASK, SYSTEM AND METHOD FOR MANUFACTURING AN OPTOELECTRONIC DEVICE

(30) Priorité: 29.06.2020 FR 2006775
(43) Date de publication de la demande: 12.01.2022
(73) Titulaire: Aledia, 38130 Echirolles (FR)
(72) Inventeur: MOTTIN, Eric, 38950 St Martin le Vinoux (FR); CAICEDO, Nohora, 38100 Grenoble (FR); Robin, Ivan-Christophe, 38000 Grenoble (FR)
(74) Mandataire: Germain Maureau

(56) Documents cités:
- CN-A- 107 346 803
- CN-A- 110 088 886
- JP-A- 2006 148 146
- JP-A- 2009 249 706

## Description

### Domaine technique de l'invention

La présente invention concerne un masque de positionnement et un système pour la fabrication d'un dispositif optoélectronique comprenant une pluralité d'objets électroniques fonctionnels fixés sur un substrat d'écran à émission lumineuse.

L'invention concerne également un procédé de fabrication d'un tel dispositif optoélectronique.

### Etat de la technique

Dans le domaine des écrans d'affichage lumineux, les éléments lumineux constituants l'écran doivent être agencés de façon matricielle d'une manière de plus en plus précise à mesure que la résolution des écrans augmente. Ces éléments lumineux comprennent chacun au moins une diode électroluminescente et sont organisés sous la forme d'un pixel multicolore ou sous la forme d'un sous-pixel monochrome.

Il est connu de produire les diodes électroluminescentes sur un support initial sous la forme d'un substrat de silicium ou de saphir et de les reporter, par une technique dite de « puce retournée » ou « flip-chip » selon la terminologie anglosaxonne, sur un support de réception différent du support initial et destiné à constituer, après ce transfert, l'écran d'affichage lumineux.

Un premier inconvénient de cette technique est que l'alignement entre les éléments lumineux et le support de réception requiert une très grande précision (inférieure à 1µm), cette contrainte devenant de plus en plus difficile à respecter au-fur et à mesure que la résolution des écrans fabriqués et la miniaturisation des diodes électroluminescentes nécessaires à ce niveau de résolution augmentent.

Un deuxième inconvénient réside dans le fait que pour réaliser des éléments lumineux multicolores, il est nécessaire de pratiquer plusieurs étapes successives de transfert d'éléments lumineux, les diodes électroluminescentes aptes à émettre selon une couleur donnée étant transférée dans chacune de ces étapes successives. Or, la méthode de thermocompression, généralement utilisée pour la technique de « puce retournée », implique qu'une force de compression soit utilisée à une température donnée pour faire le transfert, ce qui devient compliqué voire impossible lorsque des diodes électroluminescentes précédemment transférées sont déjà présentes sur le support final, au risque de provoquer des endommagements par le phénomène de compression.

Une solution à ce dernier inconvénient consiste à réaliser un support final présentant une face de réception ayant un relief pour permettre le transfert de diodes électroluminescentes sur différents emplacements prédéterminés présentant des altitudes différentes comptées dans la direction transversale au plan général du support final. Mais cette solution reste complexe à réaliser et est onéreuse de surcroît.

Enfin, les solutions actuellement implémentées sont délicates voire impossibles à mettre en oeuvre dans l'hypothèse d'un support final présentant une forme générale autre que globalement plane.

Les documents suivants appartenant à l'état de l'art son mentionnés :
CN 110 088 886 A décrit un masque de positionnement de micro DELs compris dans un appareil de fabrication d'un dispositif optoélectronique.
JP 2006 148146 A décrit un procédé de fabrication d'un dispositif optoélectronique comprenant une phase de fixation d'une pluralité de semi-conducteurs unitaires sur une face de réception du dispositif optoélectronique.

### Objet de l'invention

La présente invention a pour but de proposer une solution qui réponde à tout ou partie des problèmes précités.

Ce but peut être atteint grâce à la fourniture d'un masque de positionnement comprenant un corps délimitant une face de coopération destinée à venir en regard d'une face de réception d'un substrat d'écran à émission lumineuse, et une face d'accueil opposée à la face de coopération, le corps délimitant une pluralité de conduits répartis sur la surface du corps où chaque conduit est dimensionné pour accueillir un unique objet électronique fonctionnel semiconducteur destiné à être positionné et fixé sur la face de réception et est traversant à travers le matériau constitutif du corps et débouche du côté de la face de coopération par une première ouverture et débouche du côté de la face d'accueil par une deuxième ouverture, la section de la première ouverture étant strictement plus petite que la section de la deuxième ouverture.

Les dispositions précédemment décrites permettent de proposer un masque de positionnement configuré pour faciliter le positionnement précis d'objets électroniques fonctionnels sans nécessiter un positionnement précis au niveau de la face d'accueil.

Certains aspects préférés de ce système mais non limitatifs sont les suivants.

Selon un mode de réalisation, le corps est constitué d'un matériau polymère. Ainsi, le corps du masque de positionnement peut être produit par des procédés adaptés aux matériaux polymères.

Selon un mode de réalisation, le masque de positionnement est obtenu par un procédé d'embossage plastique.

Selon un mode de réalisation, le masque de positionnement est obtenu par un procédé d'impression 3D.

Les dispositions précédemment décrites permettent de proposer un procédé de réalisation du masque de positionnement pouvant être adapté à l'échelle industrielle, tout en présentant un coût faible.

Selon un mode de réalisation, les dimensions d'une section de la première ouverture sont comprises entre 1,1 µm et 1,1 mm.

Selon un mode de réalisation, la distance entre deux premières ouvertures est comprise entre 1 µm et 2mm.

Selon un mode de réalisation, le corps est constitué d'un matériau métallique.

Selon un mode de réalisation le conduit a une forme tronconique, la première ouverture et la deuxième ouverture constituant les bases extrêmales du tronc de cône. Par exemple, le diamètre de la deuxième ouverture peut être inférieur ou sensiblement égal à la distance séparant deux objets électroniques fonctionnels lorsqu'ils sont positionnés sur le substrat d'écran.

Selon un autre mode de réalisation, le conduit est infundibuliforme. De cette manière, le masque de positionnement avec un ou plusieurs conduits en forme d'entonnoir permet un positionnement, et donc une libération, plus rapide des objets électroniques fonctionnels en regard des entonnoirs. Ces dispositions permettent donc d'obtenir un positionnement précis au niveau de la face de réception du substrat d'écran, et de diminuer ainsi la nécessité de concordance entre le maillage du substrat écran et le maillage de l'unité d'alimentation, ou d'amortir d'éventuels jeux dimensionnels.

Selon une variante non limitative, le corps présente une forme sensiblement parallélépipédique, la surface d'accueil et la surface de coopération formant deux faces parallèles du corps.

De manière avantageuse, le corps peut présenter une forme parallélépipédique rectangle pour pouvoir s'adapter à la forme rectangulaire d'un écran ou d'une partie d'écran. Alternativement, le corps peut présenter une forme cylindrique pour pouvoir s'adapter à la forme d'une plaque de fabrication généralement utilisée dans les procédés microélectroniques.

L'invention porte également sur un système pour la fabrication d'un dispositif optoélectronique comprenant une pluralité d'objets électroniques fonctionnels semiconducteurs unitaires fixés sur une face de réception d'un substrat d'écran à émission lumineuse en étant répartis sur tout ou partie de la surface libre de la face de réception, le système comprenant :
- un masque de positionnement du type d'un de ceux décrits précédemment,
- une unité d'alimentation pour déposer librement un ensemble d'objets électroniques fonctionnels sur la face d'accueil du masque de positionnement,
- une unité de mise en place pour positionner la face de coopération du masque de positionnement en regard de la face de réception du substrat d'écran, dans une position relative telle que les objets électroniques fonctionnels positionnés dans les conduits délimités par le corps du masque de positionnement sont en contact avec la face de réception du substrat d'écran, les conduits délimités par le corps du masque de positionnement étant agencés à des emplacements prédéterminés correspondant aux emplacements de la face de réception du substrat d'écran où les objets électroniques fonctionnels du dispositif optoélectronique sont positionnés.

Par « librement », on entend que l'ensemble d'objets électroniques fonctionnels déposés sur la face d'accueil du masque de positionnement ne sont pas fixés à un autre élément.

Les dispositions précédemment décrites permettent de proposer un système de fabrication permettant le positionnement précis d'objets électroniques fonctionnels à la surface d'un substrat d'écran de manière simple et peu coûteuse. Par ailleurs, suite à la réalisation du dispositif optoélectronique, il est possible de réutiliser le masque de positionnement, ce qui permet de contenir les coûts.

De manière avantageuse, le fait de déposer librement les objets électroniques fonctionnels sur la face d'accueil du masque de positionnement permet de répartir les objets électroniques fonctionnels sur une face de réception d'un substrat d'écran sans contraindre au préalable leur positionnement vis-à-vis des orifices ménagés dans le masque de positionnement.

Certains aspects préférés de ce système mais non limitatifs sont les suivants.

Selon un mode de réalisation, les objets électroniques fonctionnels présentent une organisation libre désordonnée.

Selon un mode de réalisation, le système pour la fabrication d'un dispositif optoélectronique comprend une unité de répartition permettant de positionner un objet électronique fonctionnel parmi l'ensemble d'objets électroniques fonctionnels dans chacun des conduits délimités par le corps du masque de positionnement.

Selon un mode de réalisation, l'unité d'alimentation comprend un équipement de manipulation ou un substrat de manipulation destiné à être disposé au-dessus de la surface d'accueil.

Selon ce mode de réalisation, un ou plusieurs des objets électroniques fonctionnels peuvent être séparés dudit substrat de manipulation ou dudit équipement de manipulation lorsqu'ils sont en regard d'un conduit. Dans ce cas, l'unité d'alimentation agit comme unité de répartition.

Par exemple, l'équipement de manipulation peut comprendre une poignée sur laquelle les objets électroniques fonctionnels sont collés. Ainsi, lorsque ladite poignée est disposée au-dessus du masque de positionnement, il est possible de séparer un ou plusieurs des objets électroniques fonctionnels disposés en regard d'un conduit, par exemple par l'intermédiaire d'une impulsion laser.

Les dispositions précédemment décrites permettent de séparer uniquement certains objets électroniques fonctionnels de l'unité d'alimentation dans les conduits du masque de positionnement.

Selon un mode de réalisation, l'unité de répartition peut comprendre un fluide d'agitation configuré pour définir un environnement d'agitation, ledit environnement d'agitation étant configuré pour favoriser le positionnement d'un objet électronique fonctionnel dans au moins l'un des conduits délimités par le corps du masque de positionnement.

Selon un mode de réalisation, l'unité de répartition peut comprendre un dispositif de vibration configuré pour mettre en vibration le corps du masque de positionnement.

Selon un mode de réalisation, l'unité de répartition peut comprendre une unité d'application d'un liquide destiné à contenir un objet électronique fonctionnel, ledit liquide étant en contact avec un dispositif de vibration ultrasonore, dans ce cas, la mise en vibration du liquide par le dispositif de vibration ultrasonore peut permettre de positionner un objet électronique fonctionnel dans au moins l'un des conduits délimités par le corps du masque de positionnement.

Selon un mode de réalisation, l'unité de répartition peut comprendre une unité d'application d'un fluide d'écoulement configuré pour générer un écoulement apte à positionner un objet électronique fonctionnel dans au moins un des conduits délimités par le corps du masque de positionnement.

Selon un mode de réalisation, l'unité de répartition peut comprendre une unité d'application d'un champ magnétique, comme par exemple un dispositif de génération de champ magnétique pourvu de bobines. Dans ce cas, un objet électronique fonctionnel de l'ensemble peut comprendre une partie magnétiquement sensible configurée pour permettre le positionnement de l'objet électronique fonctionnel lorsque la partie magnétiquement sensible est soumise au champ magnétique.

Selon un mode de réalisation, l'unité de répartition peut comprendre une unité d'application d'un champ électrique. Dans ce cas, un objet électronique fonctionnel de l'ensemble peut comprendre une partie électriquement sensible configurée pour permettre le positionnement de l'objet électronique fonctionnel lorsque la partie électriquement sensible est soumise au champ électrique.

Selon un mode de réalisation, l'objet électronique fonctionnel comprend un élément électroluminescent comprenant au moins une diode électroluminescente apte à émettre et/ou capter de la lumière, et éventuellement un composant électronique de commande associé à ladite au moins une diode électroluminescente comme par exemple un transistor.

Selon un mode de réalisation, l'unité de mise en place comprend des éléments d'alignement configurés pour permettre d'aligner le corps en regard de la face de réception du substrat d'écran.

Selon un mode de réalisation, chaque objet électronique fonctionnel présente une hauteur considérée suivant une direction transversale orientée transversalement à la face de réception d'un substrat d'écran à émission lumineuse, ladite hauteur étant supérieure aux dimensions dudit objet électronique fonctionnel dans un plan perpendiculaire à la direction transversale et dans lequel les dimensions de la section de la première ouverture des conduits sont inférieures à la valeur de ladite hauteur.

Les dispositions précédemment décrites permettent d'empêcher le passage de l'objet électronique fonctionnel au travers de la première ouverture dans une configuration où sa hauteur serait en travers de la première ouverture.

Selon un mode de réalisation, le corps comprend un agent de maintien disposé au niveau de la première ouverture, ledit agent de maintien étant configuré pour maintenir l'objet électronique fonctionnel dans une première configuration dans laquelle l'objet électronique fonctionnel est solidaire du corps du masque de positionnement au niveau de la surface de coopération.

Selon un mode de réalisation, l'agent de maintien est configuré pour être dans un état solide à une température cible, et dans lequel la température du corps du masque de positionnement au niveau de la première ouverture est inférieure à la température cible lorsque l'objet électronique fonctionnel est dans la première configuration.

Selon un mode de réalisation, le système pour la fabrication d'un dispositif optoélectronique peut comprendre une plaque de refroidissement, configurée pour abaisser la température au niveau de la température cible.

Selon un mode de réalisation, l'agent de maintien comprend de l'eau, et la température cible correspond à la température de solidification de l'eau, par exemple 0°C.

Selon un mode de réalisation, l'agent de maintien comprend un agent de soudure disposé de manière à clore temporairement la première ouverture 27 du conduit au niveau de la surface de coopération.

Par exemple, l'agent de soudure peut comprendre l'étain argent ou l'indium.

Selon un mode de réalisation, chaque objet électronique fonctionnel comprend une extrémité proximale destinée à être tournée du côté de la face de réception du substrat d'écran et une extrémité distale opposée et dans lequel le système comprend une unité d'orientation des objets électroniques fonctionnels par rapport au corps du masque de positionnement d'une manière telle que tout objet électronique fonctionnel débouchant du corps par la première ouverture soit orienté pour que son extrémité proximale soit en regard de la face de réception du substrat d'écran.

Selon un mode de réalisation, l'unité d'orientation comprend une unité d'application d'un fluide dans lequel les objets électroniques fonctionnels sont orientés par gravité préférentielle. Dans ce cas, chaque objet électronique fonctionnel peut être pourvu d'une partie dense présentant une densité suffisante pour la rendre préférentiellement sensible à la gravité.

Selon un mode de réalisation, l'unité d'orientation peut comprendre une unité d'application d'un champ magnétique. Dans ce cas, chaque objet électronique fonctionnel peut comprendre une partie magnétiquement sensible configurée pour permettre l'orientation de l'objet électronique fonctionnel lorsque la partie magnétiquement sensible est soumise au champ magnétique.

L'invention porte également sur un procédé de fabrication d'un dispositif optoélectronique comprenant une phase de fixation d'une pluralité d'objets électroniques fonctionnels semiconducteurs unitaires sur une face de réception d'un substrat d'écran à émission lumineuse du dispositif optoélectronique, à l'issue de laquelle les objets électroniques fonctionnels sont répartis sur tout ou partie de la surface libre de la face de réception, la phase de fixation comprenant :
- une étape de fourniture d'un masque de positionnement comprenant un corps délimitant une face de coopération destinée à venir en regard de la face de réception du substrat d'écran, et une face d'accueil opposée à la face de coopération, le corps délimitant une pluralité de conduits répartis sur la surface du corps où chaque conduit est dimensionné pour accueillir un unique objet électronique fonctionnel et est traversant à travers le matériau constitutif du corps et débouche du côté de la face de coopération par une première ouverture et débouche du côté de la face d'accueil par une deuxième ouverture, la section de la première ouverture étant strictement plus petite que la section de la deuxième ouverture,
- une étape d'alimentation pour déposer librement un ensemble d'objets électroniques fonctionnels sur la face d'accueil du masque de positionnement,
- une étape de mise en place dans laquelle la face de coopération du masque de positionnement est positionnée en regard de la face de réception du substrat d'écran, dans une position relative telle que les objets électroniques fonctionnels positionnés dans les conduits délimités par le corps du masque de positionnement sont en contact avec la face de réception du substrat d'écran, les conduits délimités par le corps du masque de positionnement étant agencés à des emplacements prédéterminés correspondant aux emplacements de la face de réception du substrat d'écran où les objets électroniques fonctionnels du dispositif optoélectronique sont positionnés.

Les dispositions précédemment décrites permettent de proposer un procédé permettant de positionner précisément des objets électroniques fonctionnels à la surface d'un substrat d'écran par un procédé simple et peu coûteux. En effet, une telle simplicité est notamment permise par le fait de déposer librement les objets électroniques fonctionnels sur la face d'accueil du masque de positionnement. Ainsi, la répartition des objets électroniques fonctionnels sur une face de réception d'un substrat d'écran peut être mise en oeuvre sans contraindre au préalable leur positionnement vis-à-vis des orifices ménagés dans le masque de positionnement.

Par ailleurs, le masque de positionnement constitue une pièce apte à maintenir les objets électroniques fonctionnels à la surface du substrat d'écran lors de l'étape de fixation. Ainsi il est possible de répartir les objets électroniques fonctionnels sur une face de réception d'un substrat d'écran quel que soit la manière dont lesdits objets électroniques ont été apportés par l'unité d'alimentation au niveau du masque de positionnement lors de l'étape d'alimentation, et de pouvoir maintenir le positionnement desdits objets électroniques fonctionnels lors de l'étape de mise en place directement par l'intermédiaire du masque de positionnement.

Certains aspects préférés mais non limitatifs sont les suivants.

Selon un mode de réalisation, les objets électroniques fonctionnels sont agencés sur la face d'accueil du masque de positionnement selon une organisation libre désordonnée lors de l'étape d'alimentation.

Selon un mode de réalisation, la phase de fixation comprend une étape de répartition dans laquelle un objet électronique fonctionnel parmi ledit ensemble est positionné dans chacun des conduits délimités par le corps du masque de positionnement.

Selon un mode de réalisation, l'étape de répartition peut comprendre une étape d'application d'un champ magnétique. Dans ce cas, un objet électronique fonctionnel de l'ensemble peut comprendre une partie magnétiquement sensible configurée pour permettre le positionnement de l'objet électronique fonctionnel lorsque la partie magnétiquement sensible est soumise au champ magnétique.

Selon un mode de réalisation, l'étape de répartition peut comprendre une étape d'application d'un champ électrique. Dans ce cas, un objet électronique fonctionnel de l'ensemble peut comprendre une partie électriquement sensible configurée pour permettre le positionnement de l'objet électronique fonctionnel lorsque la partie électriquement sensible est soumise au champ électrique.

Selon un mode de réalisation, la phase de fixation est mise en oeuvre dans un milieu liquide.

Selon un mode de réalisation, l'étape de répartition peut être réalisée dans un fluide d'agitation configuré pour définir un environnement d'agitation, ledit environnement d'agitation étant configuré pour favoriser le positionnement d'un objet électronique fonctionnel dans au moins l'un des conduits délimités par le corps du masque de positionnement.

Selon un mode de réalisation, l'étape de répartition peut comprendre une étape de mise en vibration du corps de positionnement par exemple par l'intermédiaire d'un dispositif de vibration. Par exemple, l'étape de répartition peut être réalisée dans un liquide destiné à contenir un objet électronique fonctionnel, ledit liquide étant en contact avec un dispositif de vibration ultrasonore. Dans ce cas, l'étape de répartition peut comprendre une étape de mise en vibration du liquide par le dispositif de vibration ultrasonore de manière à positionner un objet électronique fonctionnel dans au moins l'un des conduits délimités par le corps du masque de positionnement.

Selon un mode de réalisation, l'étape de répartition peut comprendre une étape d'application d'un fluide d'écoulement configuré pour permettre un écoulement permettant le positionnement d'un objet électronique fonctionnel dans au moins l'un des conduits délimités par le corps du masque de positionnement. Par exemple, l'objet électronique fonctionnel peut comprendre une couche dense constituée dans un matériau ayant une densité supérieure aux autres matériaux constitutifs de l'objet électronique fonctionnel, ladite couche dense étant positionnée sur une surface de l'objet électronique fonctionnel destinée à être placée au contact du support d'écran. Par exemple la couche dense peut être constituée de fer ou d'or. Dans ce cas, le fluide d'écoulement peut comprendre l'eau et l'écoulement de l'objet électronique fonctionnel peut être réalisé par action de la gravité.

Selon un mode de réalisation, la phase de fixation comprend une étape de solidarisation mise en oeuvre avant l'étape de mise en place, dans laquelle au moins une partie de l'objet électronique fonctionnel est solidarisé avec au moins une partie du corps du masque de positionnement au niveau de la première ouverture, puis une étape de désolidarisation dans laquelle l'objet électronique fonctionnel est désolidarisé de ladite au moins une partie du corps du masque de positionnement.

Selon un mode de réalisation, l'objet électronique fonctionnel est pourvu d'un élément d'affinité configuré pour être solidarisé avec ladite au moins une partie du corps du masque de positionnement au niveau de la première ouverture.

Selon un mode de réalisation, l'élément d'affinité comprend une surface ayant subi un traitement de surface hydrophile ou hydrophobe configurée pour interagir avec le corps du masque de positionnement ayant subi respectivement un traitement de surface hydrophile ou hydrophobe au niveau de la première ouverture.

Selon un mode de réalisation, l'étape de solidarisation comprend un abaissement de la température du milieu liquide à une température inférieure à la température de solidification du milieu liquide au niveau de la surface de coopération de manière à solidifier le milieu liquide de manière à solidariser l'objet électronique fonctionnel au niveau de la surface de coopération, et dans lequel l'étape de désolidarisation comprend une élévation de la température du milieu liquide à une température strictement supérieure à la température de solidification du milieu liquide.

Selon un mode de réalisation, le milieu liquide est constitué par de l'eau, l'abaissement de la température peut donc être réalisé à une température inférieure à 0°C au niveau de la surface de coopération de manière à solidifier l'eau au niveau de la surface de coopération, et l'élévation de la température est réalisée à une température supérieure à 0°C.

Selon un mode de réalisation, la phase de fixation comprend une étape de retrait, successive à l'étape de mise en place, dans laquelle le contact entre le masque de positionnement et le substrat d'écran est supprimé.

De manière avantageuse, l'étape de retrait permet de réutiliser le masque de positionnement.

Selon un mode de réalisation, la phase de fixation comprend une étape de fixation des objets électronique fonctionnels sur la face de réception du substrat d'écran, dans laquelle un agent de fixation solidarise les objets électroniques fonctionnels au substrat d'écran.

Selon un mode de réalisation, l'agent de maintien comprend un agent de soudure disposé de manière à sceller le conduit au niveau de la surface de coopération. Par exemple, l'agent de soudure peut comprendre l'étain argent, ou l'indium. Dans ce cas, l'agent de maintien peut possiblement également agir comme agent de fixation en solidarisant les objets électroniques fonctionnels au substrat d'écran.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
[Fig. 1] La figure 1 est une vue en perspective d'un système pour la fabrication d'un dispositif optoélectronique selon un mode de réalisation particulier de l'invention.
[Fig. 2] La figure 2 est une vue en coupe d'un système pour la fabrication d'un dispositif optoélectronique présentant l'unité d'alimentation et l'unité de répartition, selon un mode de réalisation particulier de l'invention.
[Fig. 3] La figure 3 est une vue en coupe d'un système pour la fabrication d'un dispositif optoélectronique selon un mode de réalisation particulier de l'invention comprenant un dispositif de vibration.
[Fig. 4] La figure 4 est une vue en coupe d'un système pour la fabrication d'un dispositif optoélectronique selon un mode de réalisation particulier de l'invention comprenant un dispositif de génération de champ magnétique.
[Fig. 5] La figure 5 est une vue en coupe d'un système pour la fabrication d'un dispositif optoélectronique selon un mode de réalisation particulier de l'invention comprenant un agent de maintien disposé au niveau de la première ouverture.
[Fig. 6] La figure 6 est une vue en coupe d'un système pour la fabrication d'un dispositif optoélectronique selon un mode de réalisation particulier de l'invention comprenant une plaque de refroidissement.
[Fig. 7] La figure 7 est une vue schématique d'un procédé de fabrication d'un dispositif optoélectronique selon un mode de réalisation de l'invention.

### Description détaillée

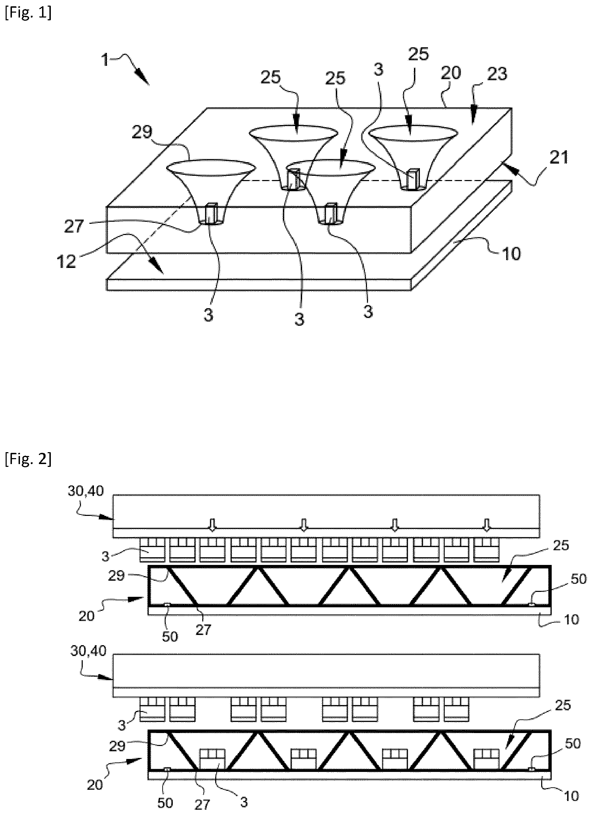

Sur les figures 1 à 7 et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

Comme illustré sur la figure 1, l'invention concerne un masque de positionnement 20, et un système pour la fabrication d'un dispositif optoélectronique 1 comprenant une pluralité d'objets électroniques fonctionnels 3 semiconducteurs unitaires. Ces objets électroniques fonctionnels 3 sont destinés à être fixés sur une face de réception 12 d'un substrat d'écran 10 à émission lumineuse en étant répartis sur tout ou partie de la surface libre de la face de réception 12. Selon un mode de réalisation, chaque objet électronique fonctionnel 3 comprend un élément électroluminescent comprenant au moins une diode électroluminescente apte à émettre et/ou capter de la lumière, et éventuellement un composant électronique de commande associé à ladite au moins une diode électroluminescente, comme par exemple un transistor.

Selon une variante non limitative, les objets électroniques fonctionnels 3 peuvent présenter des dimensions comprises entre 1 µm et 1mm. Par ailleurs, la distance entre deux objets électroniques fonctionnels 3 sur la face de réception 12 du substrat d'écran 10 est comprise entre 1 µm et 2 mm.

Comme il sera détaillé après, l'invention concerne également un procédé de fabrication d'un tel dispositif optoélectronique 1.

Le système pour la fabrication d'un dispositif optoélectronique 1 comprend le masque de positionnement 20 comprenant un corps délimitant une face de coopération 21 destinée à venir en regard de la face de réception 12 du substrat d'écran 10, et une face d'accueil 23 opposée à la face de coopération 21.

Selon une variante non limitative, le corps présente une forme sensiblement parallélépipédique, la surface d'accueil 23 et la surface de coopération 21 formant deux faces parallèles du corps. De manière avantageuse, le corps peut présenter une forme parallélépipédique rectangle pour pouvoir s'adapter à la forme rectangulaire d'un écran ou d'une partie d'écran. Alternativement, le corps peut présenter une forme cylindrique pour pouvoir s'adapter à la forme d'une plaque de fabrication généralement utilisée dans les procédés microélectroniques.

Selon un mode de réalisation, le corps est constitué d'un matériau polymère, et notamment le masque de positionnement 20 peut être obtenu par un procédé adapté aux matériaux polymères comme l'embossage plastique, ou l'impression 3D. De cette manière, le procédé de réalisation du masque de positionnement peut être adapté à l'échelle industrielle, et représente un coût faible.

Alternativement, le corps peut être constitué d'un matériau métallique.

Le corps du masque de positionnement 20 délimite une pluralité de conduits 25 répartis sur la surface du corps où chaque conduit 25 est dimensionné pour accueillir un unique objet électronique fonctionnel 3. Le mode de réalisation non limitatif représenté sur la figure 1 présente quatre conduits 25 répartis sur la surface du corps. Chaque conduit 25 est traversant à travers le matériau constitutif du corps et débouche du côté de la face de coopération 21 par une première ouverture 27 et débouche du côté de la face d'accueil 23 par une deuxième ouverture 29. La première ouverture 27 est façonnée de sorte que sa section soit strictement plus petite que la section de la deuxième ouverture 29. Par exemple le conduit 25 peut être infundibuliforme, la première ouverture 27 formant l'ouverture étroite de l'entonnoir et la deuxième ouverture 29 formant l'ouverture large de l'entonnoir.

De cette manière, le masque de positionnement 20 avec un ou plusieurs conduits 25 en forme d'entonnoir permet un positionnement, et donc une libération, plus rapide des objets électroniques fonctionnels 3 en regard des entonnoirs. Ces dispositions permettent donc d'obtenir un positionnement précis au niveau de la face de réception 12 du substrat d'écran 10. En effet, un conduit 25 infundibuliforme permet d'accueillir plus facilement un objet électronique fonctionnel 3.

Selon un mode de réalisation non représenté le conduit 25 peut avoir une forme tronconique, la première ouverture 27 et la deuxième ouverture 29 constituant les bases extrêmales du tronc de cône. Par exemple, le diamètre de la deuxième ouverture 29 peut être inférieur ou sensiblement égal à la distance séparant deux objets électroniques fonctionnels 3 lorsqu'ils sont positionnés sur le substrat d'écran 10.

Le système pour la fabrication d'un dispositif optoélectronique 1 comprend une unité d'alimentation 30 pour déposer librement un ensemble d'objets électroniques fonctionnels 3 sur la face d'accueil 23 du masque de positionnement 20. Par exemple, les objets électroniques fonctionnels 3 peuvent présenter une organisation libre désordonnée. De manière avantageuse, le fait de déposer librement les objets électroniques fonctionnels 3 sur la face d'accueil 23 du masque de positionnement 20 permet de répartir les objets électroniques fonctionnels 3 sur une face de réception 12 d'un substrat d'écran 10 sans contraindre au préalable leur positionnement vis-à-vis des orifices ménagés dans le masque de positionnement 20.

De plus, le système pour la fabrication d'un dispositif optoélectronique 1 peut comprendre une unité de répartition 40 permettant de positionner un objet électronique fonctionnel 3 parmi ledit ensemble dans chacun des conduits 25 délimités par le corps du masque de positionnement 20.

La figure 2 illustre un mode de réalisation dans lequel l'unité d'alimentation 30 comprend un équipement de manipulation destiné à être disposé au-dessus de la face d'accueil 23 du masque de positionnement 20. Par exemple, l'équipement de manipulation peut comprendre une poignée sur laquelle les objets électroniques fonctionnels 3 sont collés. Ainsi lorsque ladite poignée est disposée au-dessus du masque de positionnement 20, il est possible de séparer un ou plusieurs des objets électroniques fonctionnels 3 disposés en regard d'un conduit 25, par exemple par l'intermédiaire d'une impulsion laser. Dans ce cas, l'unité d'alimentation 30 agit comme unité de répartition 40.

Les dispositions précédemment décrites permettent de séparer uniquement certains objets électroniques fonctionnels 3 de l'unité d'alimentation 30 dans les conduits 25 du masque de positionnement 20. De manière synergique, l'unité de répartition 40 permet de diminuer ainsi la nécessité de concordance entre le maillage du substrat écran 10 et le maillage de l'unité d'alimentation 30, ou d'amortir d'éventuels jeux dimensionnels.

Selon un mode de réalisation, l'unité de répartition 40 peut comprendre une unité d'application d'un fluide d'écoulement configuré pour générer un écoulement apte à positionner un objet électronique fonctionnel 3 dans au moins un des conduits 25 délimités par le corps du masque de positionnement 20.

De manière avantageuse, chaque objet électronique fonctionnel 3 peut comprendre une extrémité proximale 32 destinée à être tournée du côté de la face de réception 12 du substrat d'écran 10 et une extrémité distale 34 opposée et dans lequel le système comprend une unité d'orientation 60 des objets électroniques fonctionnels 3 par rapport au corps du masque de positionnement 20 d'une manière telle que tout objet électronique fonctionnel 3 débouchant du corps par la première ouverture 27 soit orienté pour que son extrémité proximale 32 soit en regard de la face de réception 12 du substrat d'écran 10.

En d'autres termes, l'unité d'orientation 60 est destiné à permettre l'orientation d'un objet électronique fonctionnel 3 dans le conduit 25 vis-à-vis de ses extrémités proximale 32 et distale 34.

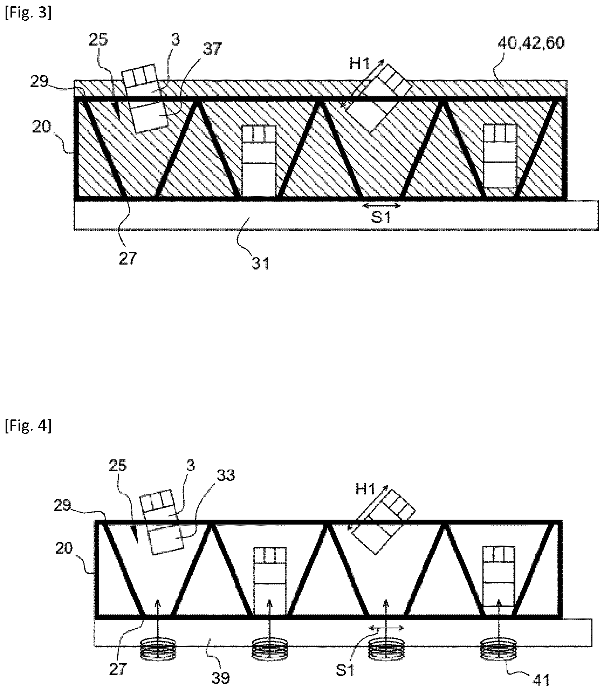

La figure 3 illustre un mode de réalisation dans lequel l'unité de répartition 40 comprend un fluide d'agitation 42 configuré pour définir un environnement d'agitation configuré pour favoriser le positionnement d'un objet électronique fonctionnel 3 dans au moins l'un des conduits 25 délimités par le corps du masque de positionnement 20.

Par exemple, chaque objet électronique fonctionnel 3 peut présenter une hauteur H1 considérée suivant une direction transversale orientée transversalement à la face de réception 12 du substrat d'écran 10 à émission lumineuse. La hauteur H1 peut être supérieure aux dimensions de l'objet électronique fonctionnel 3 dans un plan perpendiculaire à la direction transversale et les dimensions de la section S1 de la première ouverture 27 des conduits 25 peut être inférieure à la valeur de la hauteur H1.

Ainsi, les dispositions précédemment décrites permettent d'empêcher le passage de l'objet électronique fonctionnel 3 au travers de la première ouverture 27 dans une configuration où sa hauteur H1 serait en travers de la première ouverture 27.

De manière avantageuse, l'unité de répartition 40 peut comprendre un dispositif de vibration 31 configuré pour mettre en vibration le corps du masque de positionnement 20. Dans ce cas, l'unité de répartition 40 peut comprendre une unité d'application d'un liquide destiné à contenir l'objet électronique fonctionnel 3. Le liquide étant en contact avec un dispositif de vibration 31 ultrasonore peut ainsi être mis en vibration et peut permettre de positionner l'objet électronique fonctionnel 3 dans au moins l'un des conduits 25 délimités par le corps du masque de positionnement 20.

Alternativement ou conjointement, l'unité d'orientation 60 peut comprendre une unité d'application d'un fluide, ledit fluide pouvant être le fluide d'agitation 42, dans lequel les objets électroniques fonctionnels 3 sont orientés par gravité préférentielle. Dans ce cas, chaque objet électronique fonctionnel 3 peut être pourvu d'une partie dense 37 présentant une densité suffisante pour rendre l'objet électronique fonctionnel 3 sensible à la gravité préférentiellement au niveau de la partie dense 37.

La figure 4 illustre un mode de réalisation dans lequel, l'unité d'orientation 60 comprend une unité d'application d'un champ magnétique, comme par exemple un dispositif de génération de champ magnétique 39 pourvu de bobines 41. Dans ce cas, chaque objet électronique fonctionnel 3 peut comprendre une partie magnétiquement sensible 33 configurée pour permettre l'orientation de l'objet électronique fonctionnel 3 lorsque la partie magnétiquement sensible 33 est soumise au champ magnétique.

Selon un mode de réalisation, l'unité de répartition 40 peut comprendre une unité d'application d'un champ magnétique, comme par exemple un dispositif de génération de champ magnétique 39 pourvu de bobines 41. Dans ce cas, un objet électronique fonctionnel 3 de l'ensemble peut comprendre une partie magnétiquement sensible 33 configurée pour permettre le positionnement de l'objet électronique fonctionnel 3 lorsque la partie magnétiquement sensible 33 est soumise au champ magnétique.

Il est donc possible que le champ magnétique généré par le dispositif de génération de champ magnétique 39 soit appliqué pour orienter l'objet électronique fonctionnel 3 uniquement, ou pour positionner l'objet fonctionnel 3 au niveau de la première ouverture 27 uniquement, ou pour réaliser à la fois l'orientation de l'objet électronique fonctionnel 3 et son positionnement.

Selon un mode de réalisation non représenté, l'unité de répartition 40 peut comprendre une unité d'application d'un champ électrique. Dans ce cas, un objet électronique fonctionnel 3 de l'ensemble peut comprendre une partie électriquement sensible configurée pour permettre le positionnement de l'objet électronique fonctionnel 3 lorsque la partie électriquement sensible est soumise au champ électrique.

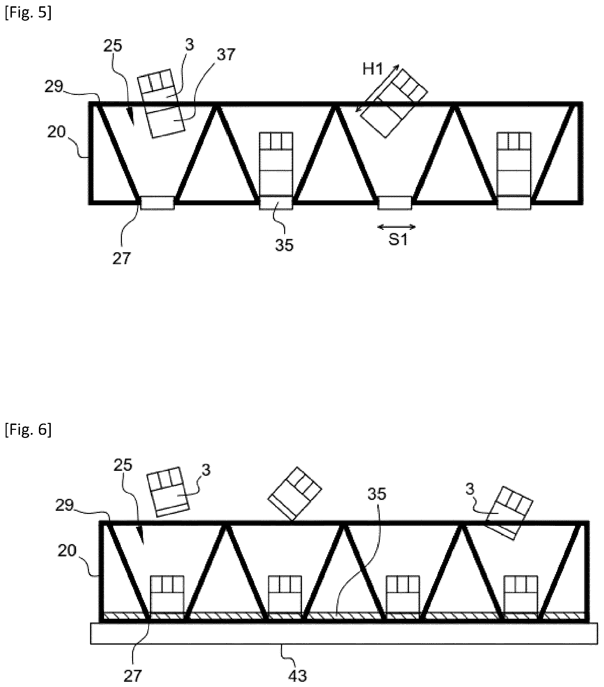

En référence aux figures 5 et 6, le corps du masque de positionnement 20 peut comprendre un agent de maintien 35 disposé au niveau de la première ouverture 27. L'agent de maintien 35 peut notamment être configuré pour maintenir l'objet électronique fonctionnel 3 dans une première configuration dans laquelle l'objet électronique fonctionnel 3 est solidaire du corps du masque de positionnement 20 au niveau de la surface de coopération 21.

Sur la variante présentée sur la figure 5, l'agent de maintien 35 comprend un agent de soudure disposé de manière à clore temporairement la première ouverture 27 du conduit 25 au niveau de la surface de coopération 21. Par exemple, l'agent de soudure peut comprendre l'étain argent ou l'indium.

Sur la variante illustrée sur la figure 6, l'agent de maintien 35 est configuré pour être dans un état solide à une température cible, et dans lequel la température du corps du masque de positionnement 20 au niveau de la première ouverture 27 est inférieure à la température cible lorsque l'objet électronique fonctionnel 3 est dans la première configuration. Par exemple, l'agent de maintien 35 comprend de l'eau, et la température cible correspond à la température de solidification de l'eau, par exemple 0°C. Dans ce cas, le système pour la fabrication d'un dispositif optoélectronique 1 peut comprendre une plaque de refroidissement 43, configurée pour abaisser la température au niveau de la température cible, de manière à solidifier l'eau au niveau de la première ouverture 27, et ainsi former l'agent de maintien 35.

Enfin, le système pour la fabrication d'un dispositif optoélectronique 1 comprend une unité de mise en place 50 pour positionner la face de coopération 21 du masque de positionnement 20 en regard de la face de réception 12 du substrat d'écran 10, dans une position relative telle que les objets électroniques fonctionnels 3 positionnés dans les conduits 25 délimités par le corps du masque de positionnement 20 sont en contact avec la face de réception 12 du substrat d'écran 10.

Selon un mode de réalisation, l'unité de mise en place 50 comprend des éléments d'alignement, comme par exemple des croix d'alignement associées à des dispositifs optiques ou des lasers, configurés pour permettre d'aligner le corps en regard de la face de réception 12 du substrat d'écran 10. Les conduits 25 délimités par le corps du masque de positionnement 20 peuvent alors être agencés à des emplacements prédéterminés correspondant aux emplacements de la face de réception 12 du substrat d'écran 10 où les objets électroniques fonctionnels 3 du dispositif optoélectronique sont positionnés. Par exemple, les emplacements prédéterminés peuvent correspondre à un maillage carré de la face de réception 12 du substrat d'écran 10 ayant une longueur de maille sensiblement égale à 100µm.

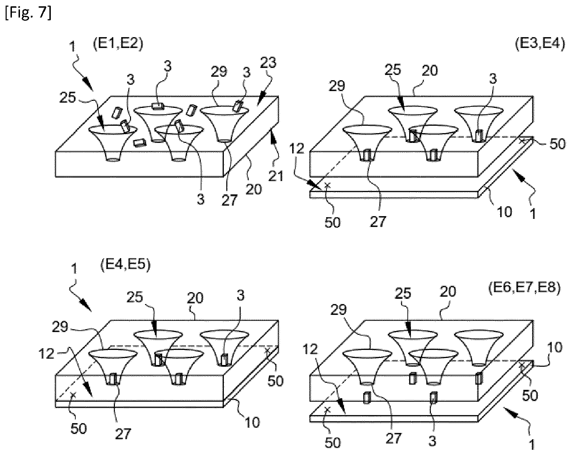

Comme indiqué précédemment, l'invention concerne également un procédé de fabrication d'un dispositif optoélectronique. La figure 7 illustre un mode de mise en oeuvre dudit procédé.

Le procédé de fabrication d'un dispositif optoélectronique comprend une phase de fixation d'une pluralité d'objets électroniques fonctionnels 3 semiconducteurs unitaires sur une face de réception 12 d'un substrat d'écran 10 à émission lumineuse du dispositif optoélectronique, à l'issue de laquelle les objets électroniques fonctionnels 3 sont répartis sur tout ou partie de la surface libre de la face de réception 12.

La phase de fixation comprend tout d'abord une étape E1 de fourniture d'un masque de positionnement 20 comprenant un corps délimitant une face de coopération 21 destinée à venir en regard de la face de réception 12 du substrat d'écran 10, et une face d'accueil 23 opposée à la face de coopération 21, le corps délimitant une pluralité de conduits 25 répartis sur la surface du corps où chaque conduit 25 est dimensionné pour accueillir un unique objet électronique fonctionnel 3 et est traversant à travers le matériau constitutif du corps et débouche du côté de la face de coopération 21 par une première ouverture 27 et débouche du côté de la face d'accueil 23 par une deuxième ouverture 29, la section S1 de la première ouverture 27 étant strictement plus petite que la section S1 de la deuxième ouverture 29.

Puis, lors d'une étape E2 d'alimentation, un ensemble d'objets électroniques fonctionnels 3 sont déposés librement sur la face d'accueil 23 du masque de positionnement 20. Par exemple, l'étape E2 d'alimentation peut être mise en oeuvre de manière que les objets électroniques fonctionnels 3 sont agencés sur la face d'accueil 23 du masque de positionnement 20 selon une organisation libre désordonnée. Ainsi, la répartition des objets électroniques fonctionnels 3 sur une face de réception 12 d'un substrat d'écran 10 peut être mise en oeuvre sans contraindre au préalable leur positionnement vis-à-vis des orifices ménagés dans le masque de positionnement 20.

Un objet électronique fonctionnel 3 parmi ledit ensemble peut ensuite être positionné dans chacun des conduits 25 délimités par le corps du masque de positionnement 20 lors d'une étape E3 de répartition.

Selon un mode de mise en oeuvre, l'unité d'alimentation 30 peut comprendre une poignée sur laquelle les objets électroniques fonctionnels 3 sont collés. Ainsi, lorsque ladite poignée est disposée au-dessus du masque de positionnement 20, l'étape E2 d'alimentation peut être réalisée en séparant un ou plusieurs des objets électroniques fonctionnels 3 disposés en regard d'un conduit 25, par exemple par l'intermédiaire d'une impulsion laser.

Selon un mode de réalisation, l'étape E3 de répartition peut comprendre une étape d'application d'un champ magnétique. Dans ce cas, un objet électronique fonctionnel 3 de l'ensemble peut comprendre une partie magnétiquement sensible 33 configurée pour permettre le positionnement de l'objet électronique fonctionnel 3 lorsque la partie magnétiquement sensible 33 est soumise au champ magnétique.

Selon un mode de réalisation, l'étape E3 de répartition peut comprendre une étape d'application d'un champ électrique. Dans ce cas, un objet électronique fonctionnel 3 de l'ensemble peut comprendre une partie électriquement sensible configurée pour permettre le positionnement de l'objet électronique fonctionnel 3 lorsque la partie électriquement sensible est soumise au champ électrique.

Selon une variante particulière, la phase de fixation peut être mise en oeuvre dans un milieu liquide.

Dans ce cas, l'étape E3 de répartition peut être réalisée dans un fluide d'agitation 42 configuré pour définir un environnement d'agitation configuré pour favoriser le positionnement d'un objet électronique fonctionnel 3 dans au moins l'un des conduits 25 délimités par le corps du masque de positionnement 20.

Selon un mode de réalisation, l'étape E3 de répartition peut comprendre une étape de mise en vibration du corps de positionnement par exemple par l'intermédiaire d'un dispositif de vibration 31, par exemple un dispositif de vibration 31 ultrasonore. Ainsi, lorsque l'étape de répartition est réalisée dans un liquide contenant l'objet électronique fonctionnel 3, la mise en vibration du liquide par le dispositif de vibration 31 ultrasonore peut permettre de positionner ledit objet électronique fonctionnel 3 dans au moins l'un des conduits 25 délimités par le corps du masque de positionnement 20.

Selon un mode de réalisation, l'étape E3 de répartition peut comprendre une étape d'application d'un fluide d'écoulement configuré pour permettre le positionnement d'un objet électronique fonctionnel 3 par écoulement dans au moins l'un des conduits 25 délimités par le corps du masque de positionnement 20. Par exemple, l'objet électronique fonctionnel 3 peut comprendre une couche dense constituée dans un matériau ayant une densité supérieure aux autres matériaux constitutif de l'objet électronique fonctionnel 3, comme le fer ou l'or, ladite couche dense étant positionnée sur une surface de l'objet électronique fonctionnel 3 destinée à être placée au contact du support d'écran. Dans ce cas, le fluide d'écoulement peut comprendre l'eau et l'écoulement de l'objet électronique fonctionnel 3 peut être réalisé par action de la gravité.

La phase de fixation peut ensuite comprendre une étape E4 de solidarisation dans laquelle au moins une partie de l'objet électronique fonctionnel 3 est solidarisé avec au moins une partie du corps du masque de positionnement 20 au niveau de la première ouverture 27. Par exemple, l'objet électronique fonctionnel 3 peut être pourvu d'un élément d'affinité configuré pour être solidarisé avec ladite au moins une partie du corps du masque de positionnement 20 au niveau de la première ouverture 27.

Selon un première variante non limitative, l'élément d'affinité comprend une surface ayant subi un traitement de surface hydrophile ou hydrophobe, ladite surface étant configurée pour interagir avec le corps du masque de positionnement 20 ayant subi respectivement un traitement de surface hydrophile ou hydrophobe au niveau de la première ouverture 27.

Selon un autre variante, l'étape E4 de solidarisation peut comprendre un abaissement de la température du milieu liquide à une température inférieure à la température de solidification du milieu liquide au niveau de la surface de coopération 21 de manière à solidifier le milieu liquide pour solidariser l'objet électronique fonctionnel 3 au niveau de la surface de coopération 21. Par exemple, le milieu liquide peut être constitué par de l'eau, l'abaissement de la température peut donc être réalisé à une température inférieure à 0°C au niveau de la surface de coopération 21 de manière à solidifier l'eau au niveau de la surface de coopération 21.

La phase de fixation comprend ensuite une étape E5 de mise en place dans laquelle la face de coopération 21 du masque de positionnement 20 est positionnée en regard de la face de réception 12 du substrat d'écran 10, dans une position relative telle que les objets électroniques fonctionnels 3 positionnés dans les conduits 25 délimités par le corps du masque de positionnement 20 sont en contact avec la face de réception 12 du substrat d'écran 10, les conduits 25 délimités par le corps du masque de positionnement 20 étant agencés à des emplacements prédéterminés correspondant aux emplacements de la face de réception 12 du substrat d'écran 10 où les objets électroniques fonctionnels 3 du dispositif optoélectronique sont positionnés.

La phase de fixation peut ensuite comprendre une étape E6 de désolidarisation dans laquelle l'objet électronique fonctionnel 3 est désolidarisé de ladite au moins une partie du corps du masque de positionnement 20.

Selon la variante dans laquelle l'étape E4 de solidarisation comprend un abaissement de la température du milieu liquide, l'étape E6 de désolidarisation peut comprendre une élévation de la température du milieu liquide à une température strictement supérieure à la température de solidification du milieu liquide. Par exemple si le milieu liquide est constitué par de l'eau, l'élévation de la température peut être réalisée à une température supérieure à 0°C.

Il est possible que l'étape E6 de désolidarisation soit réalisée avant ou après l'étape E5 de mise en place du masque de positionnement 20 contre la face de réception 12 du substrat d'écran 10.

Successivement à l'étape E5 de mise en place, la phase de fixation peut comprendre une étape E7 de retrait, dans laquelle le contact entre le masque de positionnement 20 et le substrat d'écran 10 est supprimé.

Enfin, la phase de fixation peut comprendre une étape E8 de fixation des objets électronique fonctionnels 3 sur la face de réception 12 du substrat d'écran 10, dans laquelle un agent de fixation 45 solidarise les objets électroniques fonctionnels 3 au substrat d'écran 10.

Selon un mode de réalisation, l'agent de maintien 35 comprend un agent de soudure disposé de manière à sceller le conduit 25 au niveau de la surface de coopération 21. Par exemple, l'agent de soudure peut comprendre l'étain argent, ou l'indium. Dans ce cas, l'agent de maintien 35 peut possiblement également agir comme agent de fixation 45 en solidarisant les objets électroniques fonctionnels 3 au substrat d'écran.

## Revendications

1. Système pour la fabrication d'un dispositif optoélectronique (1) comprenant une pluralité d'objets électroniques fonctionnels (3) semiconducteurs unitaires fixés sur une face de réception (12) d'un substrat d'écran (10) à émission lumineuse en étant répartis sur tout ou partie de la surface libre de la face de réception (12), le système comprenant :
- un masque de positionnement (20) comprenant un corps délimitant une face de coopération (21) destinée à venir en regard de la face de réception (12) du substrat d'écran (10) à émission lumineuse, et une face d'accueil (23) opposée à la face de coopération (21), le corps délimitant une pluralité de conduits (25) répartis sur la surface du corps où chaque conduit (25) est dimensionné pour accueillir un unique objet électronique fonctionnel (3) semiconducteur destiné à être positionné et fixé sur la face de réception (12) et est traversant à travers le matériau constitutif du corps et débouche du côté de la face de coopération (21) par une première ouverture (27) et débouche du côté de la face d'accueil (23) par une deuxième ouverture (29), la section de la première ouverture (27) étant strictement plus petite que la section de la deuxième ouverture (29);
- une unité d'alimentation (30) pour déposer librement un ensemble d'objets électroniques fonctionnels (3) sur la face d'accueil (23) du masque de positionnement (20) ;
- une unité de mise en place (50) pour positionner la face de coopération (21) du masque de positionnement (20) en regard de la face de réception (12) du substrat d'écran (10), dans une position relative telle que les objets électroniques fonctionnels (3) positionnés dans les conduits (25) délimités par le corps du masque de positionnement (20) sont en contact avec la face de réception (12) du substrat d'écran (10), les conduits (25) délimités par le corps du masque de positionnement (20) étant agencés à des emplacements prédéterminés correspondant aux emplacements de la face de réception (12) du substrat d'écran (10) où les objets électroniques fonctionnels (3) du dispositif optoélectronique sont positionnés.

2. Système pour la fabrication d'un dispositif optoélectronique (1) selon la revendication 1 dans lequel le corps du masque de positionnement (20) est constitué d'un matériau polymère.

3. Système pour la fabrication d'un dispositif optoélectronique (1) selon l'une quelconque des revendications 1 ou 2, dans lequel le masque de positionnement (20) est obtenu par un procédé d'embossage plastique.

4. Système pour la fabrication d'un dispositif optoélectronique (1) selon l'une quelconque des revendications 1 à 3, dans lequel les dimensions d'une section (S1) de la première ouverture (27) sont comprises entre 1,1 µm et 1,1 mm.

5. Système pour la fabrication d'un dispositif optoélectronique (1) selon l'une quelconque des revendications 1 à 4, dans lequel la distance entre deux premières ouvertures (27) est comprise entre 1 µm et 2mm.

6. Système pour la fabrication d'un dispositif optoélectronique (1) selon l'une quelconque des revendications 1 à 5, dans lequel les objets électroniques fonctionnels (3) présentent une organisation libre désordonnée.

7. Système pour la fabrication d'un dispositif optoélectronique (1) selon l'une quelconque des revendications 1 à 6, comprenant une unité de répartition (40) permettant de positionner un objet électronique fonctionnel (3) parmi l'ensemble d'objets électroniques fonctionnels (3) dans chacun des conduits (25) délimités par le corps du masque de positionnement (20).

8. Système pour la fabrication d'un dispositif optoélectronique (1) selon l'une quelconque des revendications 1 à 7, dans lequel chaque objet électronique fonctionnel (3) présente une hauteur (H1) considérée suivant une direction transversale orientée transversalement à la face de réception (12) d'un substrat d'écran (10) à émission lumineuse, ladite hauteur (H1) étant supérieure aux dimensions dudit objet électronique fonctionnel (3) dans un plan perpendiculaire à la direction transversale et dans lequel les dimensions de la section (S1) de la première ouverture (27) des conduits (25) sont inférieures à la valeur de ladite hauteur (H1).

9. Système pour la fabrication d'un dispositif optoélectronique (1) selon l'une quelconque des revendications 1 à 8, dans lequel le corps comprend un agent de maintien (35) disposé au niveau de la première ouverture (27), ledit agent de maintien (35) étant configuré pour maintenir l'objet électronique fonctionnel (3) dans une première configuration dans laquelle l'objet électronique fonctionnel (3) est solidaire du corps du masque de positionnement (20) au niveau de la surface de coopération (21).

10. Système pour la fabrication d'un dispositif optoélectronique (1) selon la revendication 9, dans lequel l'agent de maintien (35) est configuré pour être dans un état solide à une température cible, et dans lequel la température du corps du masque de positionnement (20) au niveau de la première ouverture (27) est inférieure à la température cible lorsque l'objet électronique fonctionnel (3) est dans la première configuration.

11. Système pour la fabrication d'un dispositif optoélectronique (1) selon l'une quelconque des revendications 1 à 10, dans lequel chaque objet électronique fonctionnel (3) comprend une extrémité proximale (32) destinée à être tournée du côté de la face de réception (12) du substrat d'écran (10) et une extrémité distale (34) opposée et dans lequel le système comprend une unité d'orientation (60) des objets électroniques fonctionnels (3) par rapport au corps du masque de positionnement (20) d'une manière telle que tout objet électronique fonctionnel (3) débouchant du corps par la première ouverture (27) soit orienté pour que son extrémité proximale (32) soit en regard de la face de réception (12) du substrat d'écran (10).

12. Procédé de fabrication d'un dispositif optoélectronique comprenant une phase de fixation d'une pluralité d'objets électroniques fonctionnels (3) semiconducteurs unitaires sur une face de réception (12) d'un substrat d'écran (10) à émission lumineuse du dispositif optoélectronique, à l'issue de laquelle les objets électroniques fonctionnels (3) sont répartis surtout ou partie de la surface libre de la face de réception (12), la phase de fixation comprenant :
- une étape (E1) de fourniture d'un masque de positionnement (20) comprenant un corps délimitant une face de coopération (21) destinée à venir en regard de la face de réception (12) du substrat d'écran (10), et une face d'accueil (23) opposée à la face de coopération (21), le corps délimitant une pluralité de conduits (25) répartis sur la surface du corps où chaque conduit (25) est dimensionné pour accueillir un unique objet électronique fonctionnel (3) et est traversant à travers le matériau constitutif du corps et débouche du côté de la face de coopération (21) par une première ouverture (27) et débouche du côté de la face d'accueil (23) par une deuxième ouverture (29), la section (S1) de la première ouverture (27) étant strictement plus petite que la section (S1) de la deuxième ouverture (29) ;
- une étape (E2) d'alimentation pour déposer librement un ensemble d'objets électroniques fonctionnels (3) sur la face d'accueil (23) du masque de positionnement (20) ;
- une étape (E5) de mise en place dans laquelle la face de coopération (21) du masque de positionnement (20) est positionnée en regard de la face de réception (12) du substrat d'écran (10), dans une position relative telle que les objets électroniques fonctionnels (3) positionnés dans les conduits (25) délimités par le corps du masque de positionnement (20) sont en contact avec la face de réception (12) du substrat d'écran (10), les conduits (25) délimités par le corps du masque de positionnement (20) étant agencés à des emplacements prédéterminés correspondant aux emplacements de la face de réception (12) du substrat d'écran (10) où les objets électroniques fonctionnels (3) du dispositif optoélectronique sont positionnés.

13. Procédé de fabrication selon la revendication 12, dans lequel les objets électroniques fonctionnels (3) sont agencés sur la face d'accueil (23) du masque de positionnement (20) selon une organisation libre désordonnée lors de l'étape (E2) d'alimentation.

14. Procédé de fabrication selon l'une quelconque des revendication 12 ou 13, dans lequel la phase de fixation comprend une étape (E3) de répartition dans laquelle un objet électronique fonctionnel (3) parmi ledit ensemble est positionné dans chacun des conduits (25) délimités par le corps du masque de positionnement (20).

15. Procédé de fabrication selon l'une quelconque des revendication 12 à 14, dans lequel la phase de fixation comprend une étape (E4) de solidarisation mise en oeuvre avant l'étape (E5) de mise en place, dans laquelle au moins une partie de l'objet électronique fonctionnel (3) est solidarisée avec au moins une partie du corps du masque de positionnement (20) au niveau de la première ouverture (27), puis une étape (E6) de désolidarisation dans laquelle l'objet électronique fonctionnel (3) est désolidarisé de ladite au moins une partie du corps du masque de positionnement (20).

16. Procédé de fabrication selon l'une quelconque des revendications 12 à 15, dans lequel la phase de fixation comprend une étape (E7) de retrait, successive à l'étape (E5) de mise en place, dans laquelle le contact entre le masque de positionnement (20) et le substrat d'écran (10) est supprimé.

17. Procédé de fabrication selon l'une quelconque des revendications 12 à 16, dans lequel la phase de fixation comprend une étape (E8) de fixation des objets électronique fonctionnels (3) sur la face de réception (12) du substrat d'écran (10), dans laquelle un agent de fixation (45) solidarise les objets électroniques fonctionnels (3) au substrat d'écran (10).

## Patentansprüche

1. System zur Herstellung einer optoelektronischen Vorrichtung (1), eine Vielzahl von einzelnen funktionalen elektronischen Halbleiterobjekten (3) umfassend, die auf einer Empfangsfläche (12) eines lichtemittierenden Schirmsubstrats (10) befestigt sind, und über die gesamte oder einen Teil der freien Oberfläche der Empfangsfläche (12) verteilt sind, wobei das System umfasst:
- eine Positionierungsmaske (20), die einen Körper umfasst, der eine Kooperationsfläche (21) abgrenzt, die dazu bestimmt ist, der Empfangsfläche (12) des lichtemittierenden Schirmsubstrats (10) zugewandt zu sein, und eine Aufnahmefläche (23) gegenüber der Kooperationsfläche (21), wobei der Körper eine Vielzahl von Kanälen (25) abgrenzt, die über die Körperoberfläche verteilt sind, wobei jeder Kanal (25) so dimensioniert ist, dass er ein einziges funktionales elektronisches Halbleiterobjekt (3) aufnimmt, das bestimmt ist, um auf der Empfangsfläche (12) positioniert und befestigt zu werden, und durchgehend ist durch das konstituierende Material des Körpers, und auf der Seite der Kooperationsfläche (21) an einer ersten Öffnung (27) ausmündet, und auf der Seite der Aufnahmefläche (23) an einer zweiten Öffnung (29) ausmündet, wobei der Abschnitt der ersten Öffnung (27) streng kleiner ist als der Abschnitt der zweiten Öffnung (29);
- eine Versorgungseinheit (30) zum freien Aufbringen eines Satzes funktionaler elektronischer Objekte (3) auf der Aufnahmefläche (23) der Positionierungsmaske (20);
- eine Einrichtungseinheit (50) zur Positionierung der Kooperationsfläche (21) der Positionierungsmaske (20) der Empfangsfläche (12) des Schirmsubstrat (10) zugewandt, in einer relativen Position, so dass die funktionalen elektronischen Objekte (3), die in den Kanälen (25) positioniert sind, die durch den Körper der Positionierungsmaske (20) abgegrenzt sind, in Kontakt mit der Empfangsfläche (12) des Schirmsubstrats (10) stehen, wobei die Kanäle (25), die durch den Körper der Positionierungsmaske (20) abgegrenzt sind, an vorbestimmten Stellen angeordnet sind, die den Stellen der Empfangsfläche (12) des Schirmsubstrats (10) entsprechen, an denen die funktionalen elektronischen Objekte (3) der optoelektronischen Vorrichtung positioniert sind.

2. System zur Herstellung einer optoelektronischen Vorrichtung (1) nach Anspruch 1, wobei der Körper der Positionierungsmaske (20) aus einem Polymermaterial besteht.

3. System zur Herstellung einer optoelektronischen Vorrichtung (1) nach einem der Ansprüche 1 oder 2, wobei die Positionierungsmaske (20) durch ein Kunststoffprägeverfahren erhalten wird.

4. System zur Herstellung einer optoelektronischen Vorrichtung (1) nach einem der Ansprüche 1 bis 3, wobei die Abmessungen eines Abschnitts (S1) der ersten Öffnung (27) zwischen 1,1 µm und 1,1 mm liegen.

5. System zur Herstellung einer optoelektronischen Vorrichtung (1) nach einem der Ansprüche 1 bis 4, wobei der Abstand zwischen zwei ersten Öffnungen (27) zwischen 1 µm und 2 mm liegt.

6. System zur Herstellung einer optoelektronischen Vorrichtung (1) nach einem der Ansprüche 1 bis 5, wobei die funktionalen elektronischen Objekte (3) eine nicht geordnete freie Organisation aufweisen.

7. System zur Herstellung einer optoelektronischen Vorrichtung (1) nach einem der Ansprüche 1 bis 6, eine Verteilungseinheit (40) umfassend, die die Positionierung eines funktionalen elektronischen Objekts (3) aus dem Satz funktionaler elektronischer Objekte (3) in jedem der Kanäle (25) ermöglicht, die durch den Körper der Positionierungsmaske (20) abgrenzt sind.

8. System zur Herstellung einer optoelektronischen Vorrichtung (1) nach einem der Ansprüche 1 bis 7, wobei jedes funktionale elektronische Objekt (3) eine berücksichtigte Höhe (H1) aufweist, die einer Querrichtung folgt, die quer zur Empfangsfläche (12) eines lichtemittierenden Schirmsubstrats (10) ausgerichtet ist, wobei die Höhe (H1) größer ist als die Abmessungen des funktionalen elektronischen Objekts (3) in einer Ebene senkrecht zur Querrichtung, und wobei die Abmessungen des Abschnitts (S1) der ersten Öffnung (27) der Kanäle (25) kleiner sind als der Wert der Höhe (H1).

9. System zur Herstellung einer optoelektronischen Vorrichtung (1) nach einem der Ansprüche 1 bis 8, wobei der Körper ein Haltemittel (35) umfasst, das im Bereich der ersten Öffnung (27) arrangiert ist, wobei das Haltemittel (35) konfiguriert ist, um das funktionale elektronische Objekt (3) in einer ersten Konfiguration zu halten, in der das funktionale elektronische Objekt (3) fest mit dem Körper der Positionierungsmaske (20) im Bereich der Kooperationsoberfläche (21) verbunden ist.

10. System zur Herstellung einer optoelektronischen Vorrichtung (1) nach Anspruch 9, wobei das Haltemittel (35) konfiguriert ist, um sich bei einer Zieltemperatur in einem festen Zustand zu befinden, und wobei die Temperatur des Körpers der Positionierungsmaske (20) im Bereich der ersten Öffnung (27) niedriger ist als die Zieltemperatur, wenn sich das funktionale elektronische Objekt (3) in der ersten Konfiguration befindet.

11. System zur Herstellung einer optoelektronischen Vorrichtung (1) nach einem der Ansprüche 1 bis 10, wobei jedes funktionale elektronische Objekt (3) ein proximales Ende (32) umfasst, das dazu bestimmt ist, auf die Seite der Empfangsfläche (12) des Schirmsubstrats (10) gedreht zu werden, und gegenüber ein distales Ende (34), und wobei das System eine Einheit zur Ausrichtung (60) der funktionalen elektronischen Objekte (3) derart in Bezug auf den Körper der Positionierungsmaske (20) umfasst, dass jedes funktionale elektronische Objekt (3), das durch die erste Öffnung (27) aus dem Körper ausmündet, so ausgerichtet ist, dass sein proximales Ende (32) der Empfangsfläche (12) des Schirmsubstrat (10) zugewandt ist.

12. Verfahren zur Herstellung einer optoelektronischen Vorrichtung, eine Phase zur Befestigung einer Vielzahl von einzelnen funktionalen elektronischen Halbleiterobjekten (3) an einer Empfangsfläche (12) eines lichtemittierenden Schirmsubstrats (10) der optoelektronischen Vorrichtung umfassend, wobei bei deren Abschluss die funktionalen elektronischen Objekte (3) über die gesamte oder einen Teil der freien Oberfläche der Empfangsfläche (12) verteilt sind, wobei die Befestigungsphase umfasst:
- einen Schritt (E1) zur Bereitstellung einer Positionierungsmaske (20), die einen Körper umfasst, der eine Kooperationsfläche (21) abgrenzt, die dazu bestimmt ist, der Empfangsfläche (12) des Schirmsubstrats (10) zugewandt zu sein, und eine Aufnahmefläche (23) gegenüber der Kooperationsfläche (21), wobei der Körper eine Vielzahl von Kanälen (25) abgrenzt, die über die Körperoberfläche verteilt sind, wobei jeder Kanal (25) so dimensioniert ist, dass er ein einziges funktionales elektronisches Objekt (3) aufnimmt, und durchgehend ist durch das konstituierende Material des Körpers, und auf der Seite der Kooperationsfläche (21) an einer ersten Öffnung (27) ausmündet, und auf der Seite der Aufnahmefläche (23) an einer zweiten Öffnung (29) ausmündet, wobei der Abschnitt (S1) der ersten Öffnung (27) streng kleiner ist als der Abschnitt (S1) der zweiten Öffnung (29);
- einen Versorgungsschritt (E2) zum freien Aufbringen eines Satzes funktionaler elektronischer Objekte (3) auf der Aufnahmefläche (23) der Positionierungsmaske (20);
- einen Einrichtungsschritt (E5), wobei die Kooperationsfläche (21) der Positionierungsmaske (20) der Empfangsfläche (12) des Schirmsubstrats (10) zugewandt positioniert wird, in einer relativen Position, so dass die funktionalen elektronischen Objekte (3), die in den Kanälen (25) positioniert sind, die durch den Körper der Positionierungsmaske (20) abgegrenzt sind, in Kontakt mit der Empfangsfläche (12) des Schirmsubstrats (10) stehen, wobei die Kanäle (25), die durch den Körper der Positionierungsmaske (20) abgegrenzt sind, an vorbestimmten Stellen angeordnet sind, die den Stellen der Empfangsfläche (12) des Schirmsubstrats (10) entsprechen, an denen die funktionalen elektronischen Objekte (3) der optoelektronischen Vorrichtung positioniert sind.

13. Herstellungsverfahren nach Anspruch 12, wobei die funktionalen elektronischen Objekte (3) auf der Aufnahmefläche (23) der Positionierungsmaske (20) gemäß einer nicht geordneten freien Organisation während des Versorgungsschritts (E2) angeordnet werden.

14. Herstellungsverfahren nach einem der Ansprüche 12 oder 13, wobei die Befestigungsphase einen Verteilungsschritt (E3) umfasst, wobei ein funktionales elektronisches Objekt (3) aus dem Satz in jedem der Kanäle (25), die durch den Körper der Positionierungsmaske (20) abgrenzt sind, positioniert wird.

15. Herstellungsverfahren nach einem der Ansprüche 12 bis 14, wobei die Befestigungsphase einen Schritt des festen Verbindens (E4) umfasst, der vor dem Einrichtungsschritt (E5) implementiert wird, wobei mindestens ein Teil des funktionalen elektronischen Objekts (3) mit mindestens einem Teil des Körpers der Positionierungsmaske (20) im Bereich der ersten Öffnung (27) fest verbunden wird, und dann einen Schritt der Verbindungslösung (E6), wobei die Verbindung des funktionalen elektronischen Objekts (3) mit dem mindestens einen Teil des Körpers der Positionierungsmaske (20) gelöst wird.

16. Herstellungsverfahren nach einem der Ansprüche 12 bis 15, wobei die Befestigungsphase einen Schritt (E7) des Entfernens umfasst, der auf den Einrichtungsschritt (E5) folgt, wobei der Kontakt zwischen der Positionierungsmaske (20) und dem Schirmsubstrat (10) entfernt wird.

17. Herstellungsverfahren nach einem der Ansprüche 12 bis 16, wobei die Befestigungsphase einen Schritt (E8) zur Befestigung der funktionalen elektronischen Objekte (3) auf der Empfangsfläche (12) des Schirmsubstrats (10) umfasst, wobei ein Befestigungsmittel (45) die funktionalen elektronischen Objekte (3) mit dem Schirmsubstrat (10) fest verbindet.

## Claims

1. A system for manufacturing an optoelectronic device (1) comprising a plurality of unitary semiconductor functional electronic objects (3) fixed on a receiving face (12) of a light-emitting screen substrate (10) by being distributed over all or part of the free surface of the receiving face (12), the system comprising:
- a positioning mask (20) comprising a body delimiting a cooperation face (21) intended to face the receiving face (12) of the light-emitting screen substrate (10), and an accommodating face (23) opposite the cooperation face (21), the body delimiting a plurality of conduits (25) distributed over the surface of the body where each conduit (25) is dimensioned to accommodate a single semiconductor functional electronic object (3) intended to be positioned and fixed on the receiving face (12) and passes through the material constituting the body and opens out on the side of the cooperation face (21) through a first opening (27) and opens out on the side of the accommodating face (23) through a second opening (29), the section of the first opening (27) being strictly smaller than the section of the second opening (29);
- a supplying unit (30) for freely depositing a set of functional electronic objects (3) on the accommodating face (23) of the positioning mask (20);
- an installation unit (50) for positioning the cooperation face (21) of the positioning mask (20) facing the receiving face (12) of the screen substrate (10), in a relative position such that the functional electronic objects (3) positioned in the conduits (25) delimited by the body of the positioning mask (20) are in contact with the receiving face (12) of the screen substrate (10), the conduits (25) delimited by the body of the positioning mask (20) being arranged at predetermined locations corresponding to the locations of the receiving face (12) of the screen substrate (10) where the functional electronic objects (3) of the optoelectronic device are positioned.

2. The system for manufacturing an optoelectronic device (1) according to claim 1, wherein the body of the positioning mask (20) consists of a polymer material.

3. The system for manufacturing an optoelectronic device (1) according to any one of claims 1 or 2, wherein the positioning mask (20) is obtained by a plastic embossing method.

4. The system for manufacturing an optoelectronic device (1) according to any one of claims 1 to 3, wherein the dimensions of a section (S1) of the first opening (27) are comprised between 1.1 µm and 1.1mm.

5. The system for manufacturing an optoelectronic device (1) according to any one of claims 1 to 4, wherein the distance between two first openings (27) is comprised between 1 µm and 2 mm.

6. The system for manufacturing an optoelectronic device (1) according to any one of claims 1 to 5, wherein the functional electronic objects (3) have a free disordered organization.

7. The system for manufacturing an optoelectronic device (1) according to any one of claims 1 to 6, comprising a distribution unit (40) making it possible to position a functional electronic object (3) among the set of functional electronic objects (3) in each of the conduits (25) delimited by the body of the positioning mask (20).

8. The system for manufacturing an optoelectronic device (1) according to any one of claims 1 to 7, wherein each functional electronic object (3) has a height (H1) considered in a transverse direction oriented transversely to the receiving face (12) of a light-emitting screen substrate (10), said height (H1) being greater than the dimensions of said functional electronic object (3) in a plane perpendicular to the transverse direction and in which the dimensions of the section (S1) of the first opening (27) of the conduits (25) are less than the value of said height (H1).

9. The system for manufacturing an optoelectronic device (1) according to any one of claims 1 to 8, wherein the body comprises a holding agent (35) disposed at the level of the first opening (27), said holding agent (35) being configured to hold the functional electronic object (3) in a first configuration in which the functional electronic object (3) is secured to the body of the positioning mask (20) at the level of the cooperation surface (21).

10. The system for manufacturing an optoelectronic device (1) according to claim 9, wherein the holding agent (35) is configured to be in a solid state at a target temperature, and wherein the temperature of the body of the positioning mask (20) at the first opening (27) is lower than the target temperature when the functional electronic object (3) is in the first configuration.

11. The system for manufacturing an optoelectronic device (1) according to any one of claims 1 to 10, wherein each functional electronic object (3) comprises a proximal end (32) intended to be turned towards the receiving face (12) of the screen substrate (10) and an opposite distal end (34) and in which the system comprises an orientation unit (60) of the functional electronic objects (3) relative to the body of the positioning mask (20) in such a way that any functional electronic object (3) opening from the body through the first opening (27) is oriented so that its proximal end (32) faces the receiving face (12) of the screen substrate (10).

12. A method for manufacturing an optoelectronic device comprising a phase of fixing a plurality of unitary semiconductor functional electronic objects (3) on a receiving face (12) of a light-emitting screen substrate (10) of the optoelectronic device, at the end of which the functional electronic objects (3) are distributed over all or part of the free surface of the receiving face (12), the fixing phase comprising:
- a step (E1) of providing a positioning mask (20) comprising a body delimiting a cooperation face (21) intended to face the receiving face (12) of the screen substrate (10), and an accommodating face (23) opposite the cooperation face (21), the body delimiting a plurality of conduits (25) distributed over the surface of the body where each conduit (25) is dimensioned to accommodate a single functional electronic object (3) and passes through the material constituting the body and opens out on the side of the cooperation face (21) through a first opening (27) and opens out on the side of the accommodating face (23) through a second opening (29), the section (S1) of the first opening (27) being strictly smaller than the section (S1) of the second opening (29);
- a supplying step (E2) for freely depositing a set of functional electronic objects (3) on the accommodating face (23) of the positioning mask (20);
- an installation step (E5) in which the cooperation face (21) of the positioning mask (20) is positioned facing the receiving face (12) of the screen substrate (10), in a relative position such that the functional electronic objects (3) positioned in the conduits (25) delimited by the body of the positioning mask (20) are in contact with the receiving face (12) of the screen substrate (10), the conduits (25) delimited by the body of the positioning mask (20) being arranged at predetermined locations corresponding to the locations of the receiving face (12) of the screen substrate (10) where the functional electronic objects (3) of the optoelectronic device are positioned.

13. The manufacturing method according to claim 12, wherein the functional electronic objects (3) are arranged on the accommodating face (23) of the positioning mask (20) according to a free disordered organization during the supplying step (E2).

14. The manufacturing method according to any one of claims 12 or 13, wherein the fixing phase comprises a distributing step (E3) in which a functional electronic object (3) among said set is positioned in each of the conduits (25) delimited by the body of the positioning mask (20).

15. The manufacturing method according to any one of claims 12 to 14, wherein the fixing phase comprises a securing step (E4) implemented before the installation step (E5), in which at least part of the functional electronic object (3) is secured with at least part of the body of the positioning mask (20) at the level of the first opening (27), then a disengaging step (E6) in which the functional electronic object (3) is disengaged from said at least part of the body of the positioning mask (20).

16. The manufacturing method according to any one of claims 12 to 15, wherein the fixing phase comprises a removing step (E7), successive to the installation step (E5), in which the contact between the positioning mask (20) and the screen substrate (10) is removed.

17. The manufacturing method according to any one of claims 12 to 16, wherein the fixing phase comprises a step (E8) of fixing functional electronic objects (3) on the receiving face (12) of the screen substrate (10), in which a fixing agent (45) secures the functional electronic objects (3) to the screen substrate (10).
